# EUROPEAN PATENT APPLICATION

(11) **EP 2 581 845 A1**
(43) Date of publication of application: **17.04.2013**
(21) Application number: 12187409.3
(22) Date of filing: 05.10.2012
(51) Int. Cl.: G06F 17/50

(54) **Design support apparatus and design support method**

(30) Priority: 11.10.2011 JP 2011224133
(71) Applicant: FUJITSU LIMITED, Kawasaki-shi, Kanagawa 211-8588 (JP)
(72) Inventor: Iemura, Kousuke, Kanagawa 211-8588 (JP)
(74) Representative: HOFFMANN EITLE

(57) **Abstract**

A first generation unit generates, with reference to logical connection information of a semiconductor integrated circuit to be designed, first information indicating logical connection information where a test circuit used for testing the operation of the semiconductor integrated circuit is not to be inserted. A second generation unit generates second information where a test circuit is to be inserted, by excluding the logical connection information indicated by the first information generated by the first generation unit from logical connection information included in test difficulty information whose parameters indicate difficulties of controllability and observability of a signal that propagates in the semiconductor integrated circuit.

## Description

### FIELD

The embodiments discussed herein relate to a design support apparatus and design support method.

### BACKGROUND

There have been known techniques for creating functional diagrams in which the operational functions of logic circuits of a semiconductor integrated circuit to be designed are represented by means of graphics, tables, characters, or others. For example, one of these known techniques is to indicate numerical values of controllability and observability on a data path in a functional diagram, so as to allow the ease of the controllability and observability of a signal on the data path to be confirmed. Please see, for example, Japanese Unexamined Patent Publication No. 7-244679.

In testing the operation of a logic circuit, a circuit designer may insert a test circuit for facilitating control in a data path which has poor controllability, poor observability, or the like, thereby making it easy to verify the operation of the logic circuit.

However, a test circuit may not be able to be inserted depending on the type of a net forming a data path, such as a clock line or scan net. In addition, there is also a problem in that a signal propagation time of a data path having a test circuit inserted therein may exceed the delay time of a critical path. If the signal propagation time exceeds the delay time of the critical path, rework may need to be done in a later design process.

### SUMMARY

As one aspect, the embodiments are intended to specify a net where a test circuit is to be inserted.

According to one aspect, there is provided a design support apparatus. The design support apparatus includes: a first generation means to generate, with reference to logical connection information of a semiconductor integrated circuit to be designed, first information indicating logical connection information where a test circuit used for testing operation of the semiconductor integrated circuit is not to be inserted; a storage means to store the first information; and a second generation means to generate second information indicating logical connection information where the test circuit is to be inserted, by excluding the logical connection information indicated by the first information stored in the storage means from logical connection information whose parameters indicate difficulties of controllability and observability of a signal that propagates in the semiconductor integrated circuit.

### BRIEF DESCRIPTION OF DRAWINGS

FIG. 1 illustrates a design support apparatus according to a first embodiment;
FIG. 2 illustrates hardware components of a design support apparatus according to a second embodiment;
FIG. 3 is a functional block diagram of the design support apparatus according to the second embodiment;
FIG. 4 illustrates one example of testability information stored in a testability information storage unit;
FIG. 5 illustrates an example of results of calculating controllability and observability;
FIGS. 6A and 6B illustrate an example of information stored in a TC non-insertability information storage unit and TC insertion difficulty information storage unit;
FIG. 7 is a flowchart illustrating an entire process of the design support apparatus according to the second embodiment;
FIG. 8 is a flowchart of a testability information generation process;
FIG. 9 is a flowchart illustrating a process of a logical connection information analysis unit;
FIG. 10 is a flowchart illustrating a process of an implementation information analysis unit;
FIG. 11 is a flowchart illustrating a process of a delay information analysis unit;
FIG. 12 is a flowchart of a display data generation process;
FIG. 13 is a flowchart of a logic circuit diagram creation process;
FIG. 14 is a flowchart of a bubble creation process;
FIGS. 15A and 15B illustrate examples of a logic circuit diagram to be displayed on a monitor;
FIGS. 16 and 17 illustrate examples of insertion of a test circuit;
FIG. 18 is a functional block diagram of a design support apparatus according to a third embodiment;
FIG. 19 illustrates an example of insertion of a test circuit according to the third embodiment;
FIG. 20 is a flowchart illustrating an entire process of the design support apparatus according to the third embodiment; and
FIG. 21 is a flowchart of a testability information generation process according to the third embodiment.

### DESCRIPTION OF EMBODIMENTS

Design support apparatuses according to several embodiments will be described below with reference to the accompanying drawings, wherein like reference numerals refer to like elements throughout.

### (a) First Embodiment

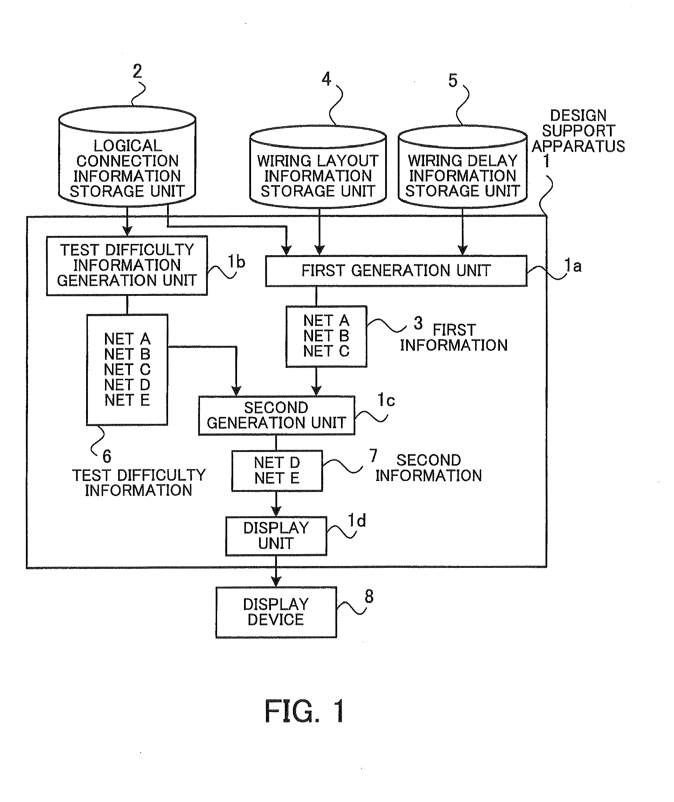

FIG. 1 illustrates a design support apparatus according to a first embodiment.

A design support apparatus (computer) 1 according to the first embodiment includes a first generation unit 1a, test difficulty information generation unit (third generation unit) 1b, second generation unit 1c, and display unit 1d. These first generation unit 1a, test difficulty information generation unit 1b, second generation unit 1c, and display unit 1d are realized by functions of a Central Processing Unit (CPU) provided in the design support apparatus 1.

The first generation unit 1a generates, with reference to logical connection information of a semiconductor integrated circuit to be designed (e.g. nets that define connections between terminals in the circuit), which is stored in a logical connection information storage unit 2, first information 3 indicating the identifier of logical connection information where a test circuit for testing the operation of the semiconductor integrated circuit is not to be inserted. For example, the first generation unit 1a determines logical connection information indicating that the type of wiring is a clock line, as logical connection information where a test circuit is not to be inserted. The first generation unit 1a then generates the first information 3 that indicates the identifier "net A" of the logical connection information where a test circuit is determined not to be inserted.

In addition, the first generation unit 1a specifies logical connection information where a test circuit is not to be inserted, with reference to wiring layout information of the semiconductor integrated circuit to be designed, which is stored in a wiring layout information storage unit 4. For example, the first generation unit 1a analyzes the wiring layout information to determine logical connection information which has space of a predetermined width or less from an adjacent wiring line, as logical connection information where a test circuit is not to be inserted. The first generation unit 1a then adds the identifier "net B" of the determined logical connection information, where a test circuit is determined not to be inserted, to the first information 3.

In addition, the first generation unit 1a specifies logical connection information where a test circuit is not to be inserted, with reference to wiring delay information of the semiconductor integrated circuit to be designed, which is stored in a wiring delay information storage unit 5. For example, the first generation unit 1a analyzes the wiring delay information to trace a path which has the longest delay time between latches and passes through specific wiring. Then, the first generation unit 1a calculates the delay time of the traced path on the basis of the wiring delay information. In the case where the calculated delay time becomes longer than the delay time of a critical path if a gate for inserting a test circuit is added to the traced path, the first generation unit 1a determines the logical connection information forming the path as logical connection information where a test circuit is not to be inserted. The first generation unit 1a then adds the identifier "net C" of the determined logical connection information, where a test circuit is determined not to be inserted, to the first information 3. In this connection, the first information 3 is stored in a storage unit (not illustrated).

The logical connection information storage unit 2, wiring layout information storage unit 4, wiring delay information storage unit 5, and storage unit for storing the first information 3 are implemented by a hard disk drive (HDD) or the like.

The test difficulty information generation unit 1b calculates values of controllability and observability with respect to each piece of logical connection information. One example of how to calculate values of controllability and observability will be described in a second embodiment. When generating test data for testing the operation of a semiconductor integrated circuit, the design support apparatus 1 uses the values of controllability and observability as information for determining whether it is easy to generate the test data for logical connection information or not. As one example, the test difficulty information generation unit 1b generates test difficulty information (third information) 6 that specifies logical connection information which has at least one of controllability and observability of a signal in a semiconductor integrated circuit to be designed less than a predetermined value, with reference to the logical connection information of the semiconductor integrated circuit stored in the logical connection information storage unit 2. The test difficulty information 6 includes the identifiers "net A" "net B" "net C", "net D", and "net E" of the specified logical connection information. In this connection, the predetermined value may be set to a value considered to indicate difficult controllability or observability, by a circuit designer in advance.

The logical connection information included in the test difficulty information 6 is logical connection information for which it is difficult to generate test data. In other words, the logical connection information included in the test difficulty information 6 is in great need for inserting a test circuit therein.

The second generation unit 1c generates second information 7 indicating logical connection information where a test circuit is to be inserted, by excluding the logical connection information included in the first information 3 generated by the first generation unit 1a from the logical connection information included in the test difficulty information 6. The second information 7 includes the identifiers "net D" and "net E" of the logical connection information where a test circuit is to be inserted.

The display unit 1d creates a logic circuit diagram of the semiconductor integrated circuit to be designed, and displays the logic circuit diagram on a display device 8 so that the logical connection information of the specified "net D" and "net E" is displayed in a distinguishable manner from the other logical connection information. As the display device 8, a device using cathode ray tube (CRT) or a liquid crystal display device may be used.

As described above, in the design support apparatus 1, the first generation unit 1a generates the first information 3. Then, the second generation unit 1c specifies the identifiers "net D" and "net E" of logical connection information where a test circuit is insertable, by excluding the logical connection information included in the first information 3 generated by the first generation unit 1a from the logical connection information included in the test difficulty information 6. As a result, logical connection information where a test circuit is insertable is specified.

In addition, the logical connection information of "net D" and "net E" is displayed in the logic circuit diagram created by the display unit 1d on the display device 8 in a distinguishable manner from the other logical connection information. This directs the circuit designer to insert a test circuit in the logical connection information of "net D" and "net E" displayed on the display device 8 and not to insert any test circuit in the other logical connection information, thereby making it possible to prevent a test circuit from being inserted into logical connection information other than those where a test circuit is insertable.

This embodiment describes the case where the circuit designer inserts a test circuit. Alternatively, the design support apparatus 1 may be designed to insert a test circuit in logical connection information specified by the second generation unit 1c.

Further, the embodiment describes a clock line as logical connection information where a test circuit is not to be inserted by way of example. Other than the clock line, a scan net, a Fix line where a value such as 0 or 1 is fixed, etc. may be exemplified for logical connection information where a test circuit is not to be inserted.

Still further, in this embodiment, the first generation unit 1a specifies logical connection information where a test circuit is not to be inserted, with reference to the wiring layout information and wiring delay information. Alternatively, the circuit designer may determine whether to refer to the wiring layout information and wiring delay information.

The following describes the disclosed design support apparatus more concretely in a second embodiment.

### (b) Second Embodiment

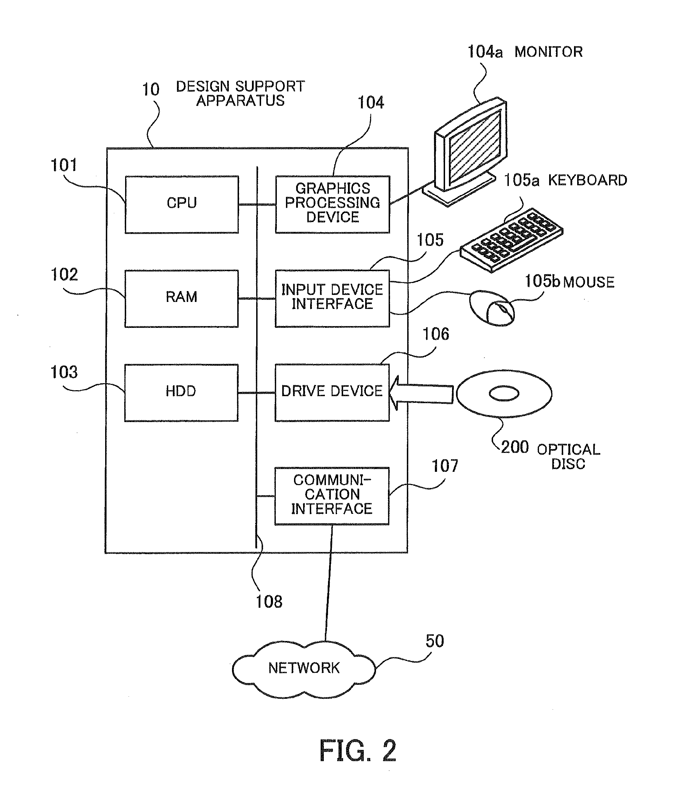

FIG. 2 illustrates hardware components of a design support apparatus according to the second embodiment.

A design support apparatus 10 is entirely controlled by a CPU 101. A RAM 102 and a plurality of peripheral devices are connected to the CPU 101 via a bus 108.

The RAM 102 is used as a main memory device of the design support apparatus 10. The RAM 102 temporarily stores at least part of Operating System (OS) programs and application programs to be executed by the CPU 101. The RAM 102 also stores various data to be used while the CPU 101 operates.

Connected to the bus 108 are a hard disk drive (HDD) 103, graphics processing device 104, input device interface 105, drive device 106, and communication interface 107.

The HDD 103 magnetically writes and reads data on an internal disk. The HDD 103 is used as a secondary storage device of the design support apparatus 10. The HDD 103 stores the OS programs, application programs, and various data. In this connection, a flash memory or another kind of semiconductor storage device may be used as a secondary storage device.

A monitor 104a is connected to the graphics processing device 104. The graphics processing device 104 displays an image on the screen of the monitor 104a under the control of the CPU 101. As the monitor 104a, a display device using CRT or a liquid crystal display device may be used.

A keyboard 105a and mouse 105b are connected to the input device interface 105. The input device interface 105 transfers signals from the keyboard 105a and mouse 105b to the CPU 101. The mouse 105b is one example of a pointing device, and another kind of pointing device such as a touch panel, tablet, touchpad, or trackball may be used.

The drive device 106 reads data from an optical disc. The optical disc is a portable recording medium such as a Universal Serial Bus (USB) memory on which data is recorded so as to be read with reflection of light. For example, when an optical drive device is used as the drive device 106, data is read from an optical disc 200 using laser light. Optical discs 200 include Blu-ray (registered trademark), Digital Versatile Disc (DVD), DVD-RAM, Compact Disc Read Only Memory (CD-ROM), CD-R (Readable)/RW (ReWritable), etc.

The communication interface 107 is connected to a network 50. The communication interface 107 performs data communications with another computer or communication apparatus via the network 50.

The processing functions of this embodiment are realized by using the above hardware components.

The design support apparatus 10 having the hardware components of FIG. 2 is provided with the following functions.

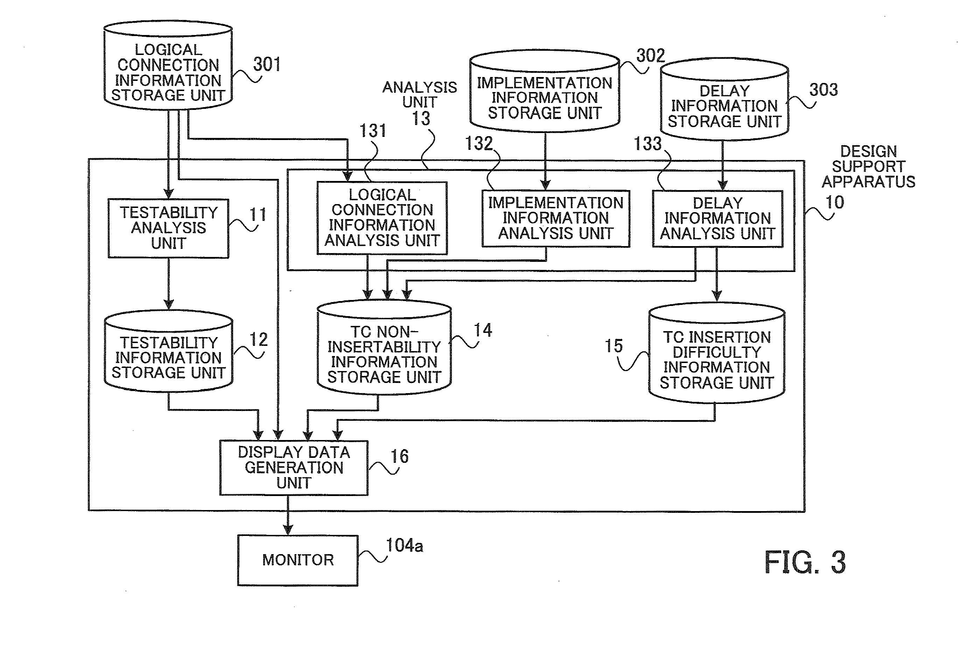

FIG. 3 is a functional block diagram of a design support apparatus according to the second embodiment.

In designing a Large Scale Integration (LSI), the design support apparatus 10 narrows down an LSI area to areas that are difficult to be diagnosed, and inserts a test circuit into each detected area in order to test the operation of LSI. The operation of LSI is tested by supplying a predetermined signal to the test circuit.

The design support apparatus 10 includes a testability analysis unit 11, testability information storage unit 12, analysis unit 13, TC non-insertability information storage unit 14, TC insertion difficulty information storage unit 15, and display data generation unit 16. The analysis unit 13 is one example of the first generation unit, and the display data generation unit 16 is one example of the second generation unit and display unit.

The testability analysis unit 11 generates testability information with reference to logical connection information stored in a logical connection information storage unit 301, and stores the generated testability information in the testability information storage unit 12. The logical connection information indicates connections between nets of an LSI to be designed and the attributes of the nets. The attributes of nets include clock line, scan net, and Fix line where a value such as 0 or 1 is fixed. The logical connection information also indicates whether an error is settable or not for each net (whether an error possibly occurs in a net or not).

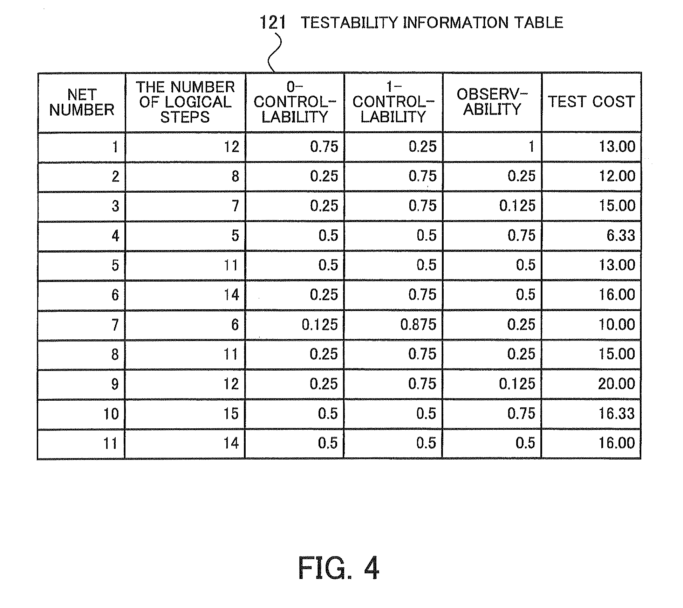

FIG. 4 illustrates one example of testability information stored in a testability information storage unit.

In the testability information storage unit 12, information is stored in tabular form. A testability information table 121 has columns for net number, the number of logical steps, 0-controllability, 1-controllability, observability, and test cost. Data arranged in a horizontal direction is associated with each other.

The net number column contains a number identifying a net.

The number-of-logical-steps column contains the number of logical steps calculated based on logical connection information. The number of logical steps is counted in such a manner that the number of logical steps is set to an initial value of 0 at an external input pin (primary input) or scan latch of LSI where a logical setting value is desirably controlled in LSI testing, and is incremented by one every time a gate is passed.

The 0-controllability column contains a value indicating 0-controllability of a net. The controllability is calculated with one of existing methods such as the Controllability Observability program (COP). In the COP, a probability of setting the logic of a net to 0 is calculated with respect to 0-controllability while a probability of setting the logic of a net to 1 is calculated with respect to 1-controllability. By setting the 0-controllability and 1-controllability of a primary input and scan latch to an initial value of 0.5, the logic of a net is set to 0 or 1 with a probability of 50 percent. For example, in the case where the input terminals of a two-input AND gate both have 1-controllability of 0.5, the output terminal of the AND gate has 1-controllability of 0.25 and 0-controllability of 0.75.

The 1-controllability column contains a value indicating 1-controllability of a net.

The observability column contains a value indicating observability of a net.

The observability is sequentially calculated in such a manner that an initial value of an external output pin (primary output) of an LSI is set to 1, and observability of an output gate is multiplied by controllability needed for fault propagation.

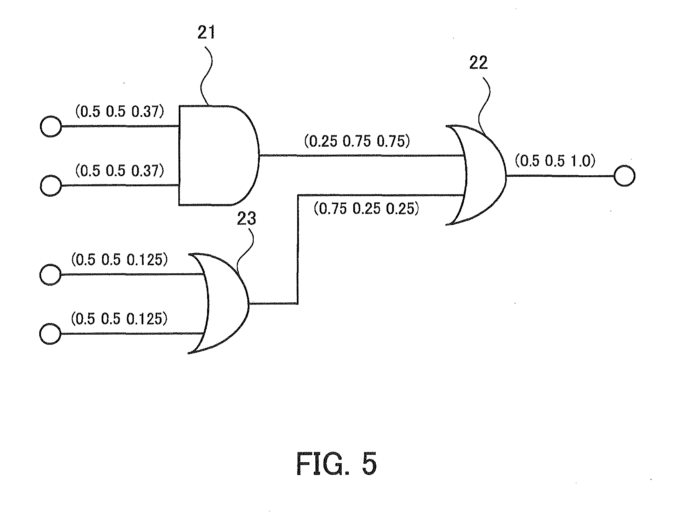

FIG. 5 illustrates an example of results of calculating controllability and observability.

Numerical values in brackets associated with each input/output terminal of an AND circuit 21, OR circuit 22, and OR circuit 23 indicate 0-controllability, 1-controllability, and observability from the left side. For example, the observability (0.75) of the output terminal of the AND circuit 21 is obtained by multiplying the observability (1) of the output terminal of the OR circuit 22 by the 1-controllability (0.75) of the input terminal of the OR circuit 22. In addition, the observability (0.37) of the input terminal of the AND circuit 21 is obtained by multiplying the observability (0.75) of the output terminal of the AND circuit 21 by the 1-controllability (0.5) of the input terminal of the AND circuit 21.

The test cost column contains a test cost as an index indicating how difficult it is to generate test data. A greater value of the test cost indicates more difficulty in generating test data. In other words, a greater value of the test cost indicates greater necessity of inserting a test circuit.

The test cost is calculated by using information such as the number of logical steps, controllability, observability, etc. For example, difficulty of diagnosing 0-fault is calculated by multiplying an inverse number of observability by 0-controllability. Difficulty of diagnosing 1-fault is calculated by multiplying an inverse number of observability by 1-controllability. Then, the test cost is calculated as a sum of the difficulty of diagnosing 0-fault, the difficulty of diagnosing 1-fault, and the number of logical steps. For example, the test cost of the net number "1" is calculated by 12 + (1 × 0.75 + 1 × 0.25). The test cost of the net number "2" is calculated by 8 + (4 × 0.25 + 4 × 0.75).

Referring back to FIG. 3, the analysis unit 13 includes a logical connection information analysis unit 131, implementation information analysis unit 132, and delay information analysis unit 133.

The logical connection information analysis unit 131 analyzes the logical connection information stored in the logical connection information storage unit 301 to specify a net where a test circuit is not to be inserted. More specifically, the logical connection information analysis unit 131 determines a net where the type of wiring is a clock line, scan net, or Fix line, as a net where a test circuit is not to be inserted (a test circuit is not insertable). This is because, if a test circuit is inserted in a net having wiring of such a type, the LSI does not operate as intended by the circuit designer.

Then, the logical connection analysis unit 131 stores the net number of the net where a test circuit is determined not to be inserted, in a test circuit (TC) non-insertability information storage unit 14.

The logical connection information analysis unit 131 also stores the net numbers of nets that are not for a representative fault and are not considered when a test circuit is inserted, in the TC non-insertability information storage unit 14. The representative fault is a fault selected from a group of equivalent faults.

The implementation information analysis unit 132 analyzes implementation information stored in the implementation information storage unit 302 to specify a net where a test circuit is not to be inserted. In this connection, the implementation information is wiring arrangement information obtained after layout. For example, the implementation information includes information associating each net of an LSI to be designed with the width of space between the net and its adjacent net. The implementation information also includes information about the gate density of the LSI.

For example, the implementation information analysis unit 132 selects one net from the implementation information. Then, if there is another net in the vicinity of either side of the selected net, the width of the space between the nets is measured. If the measured width is narrower than a width wide enough to insert a test circuit (hereinafter, referred to as a sufficient width), the selected net is determined as a net where a test circuit is not insertable, and the net number of the selected net is stored in the TC non-insertability information storage unit 14. The lower limit of the sufficient width may be determined with an LSI technology. For example, in the case of a 45nm technology (the wiring of an LSI has a width of 45nm), the lower limit of the sufficient width is determined to be 100nm (50nm × 2).

In addition, the implementation analysis unit 132 determines based on the gate density of the LSI included in the implementation information whether it is possible to arrange a gate for inserting a test circuit in a net or not. Then, the implementation analysis unit 132 stores the net number of a net where it is not possible to arrange a gate, in the TC non-insertability information storage unit 14.

The delay information analysis unit 133 analyzes delay information stored in the delay information storage unit 303 to detect a net where a test circuit is not to be inserted and a net where it is difficult to insert a test circuit. The delay information includes the nets of the LSI to be designed and the delay time for each path passing through the nets.

More specifically, the delay information analysis unit 133 selects one net from the delay information. The delay information analysis unit 133 then traces a path with the maximum delay time of a latch out of the latches passing through the selected net. Then, the delay time of the traced path is calculated on the basis of the delay information. Then, the delay information analysis unit 133 calculates a delay time for the case of inserting a test circuit in (adding a gate to) the traced path. Then, the delay information analysis unit 133 determines whether or not the delay time for the case of inserting the test circuit is equal to or greater than the limit value of the path delay time. In the case where the delay time for the case of inserting the test circuit is equal to or greater than the limit value of the path delay time, the delay information analysis unit 133 stores the net number of the selected net in the TC non-insertability information storage unit 14. Net numbers that are stored in the TC non-insertability information storage unit 14 are one example of the first information. In addition, if the delay time for the case of inserting a test circuit has no spare time, even within the limit value of the path delay time, it is determined that it is difficult to insert the test circuit, and the net number of the selected net is stored in the TC insertion difficulty information storage unit 15. Net numbers that are stored in the TC insertion difficulty information storage unit 15 are one example of the third information. The reason why the net having no spare time for a delay time is determined as a net where it is difficult to insert a test circuit is because, if a test circuit is inserted in a net having no spare time for delay time, the delay time may exceed the limit value of the path delay time depending on the layout of wiring arrangement.

For example, assume that a gate delay due to insertion of a test circuit is 15ps in an LSI with a clock frequency of 2GHz, and a circuit designer sets the limit value of a path delay time to 485ps (=1/(2GHz) - 15ps). In this case, the delay information analysis unit 133 determines that a test circuit is not insertable if the delay time of a path is 485ps or greater, and stores the net number of the selected net in the TC non-insertability information storage unit 14. In addition, the circuit designer sets a path delay time which may cause an error even a delay time of a path does not exceed the limit value depending on the wiring layout because the path delay time has no spare time enough to insert a test circuit. For example, the circuit designer determines 470ps ≤ path delay time < 485ps. In this case, the delay information analysis unit 133 determines that it is difficult to insert a test circuit in the case of 470ps ≤ path delay time < 485ps. Then, the delay information analysis unit 133 stores the net number of the selected net in the TC insertion difficulty information storage unit 15.

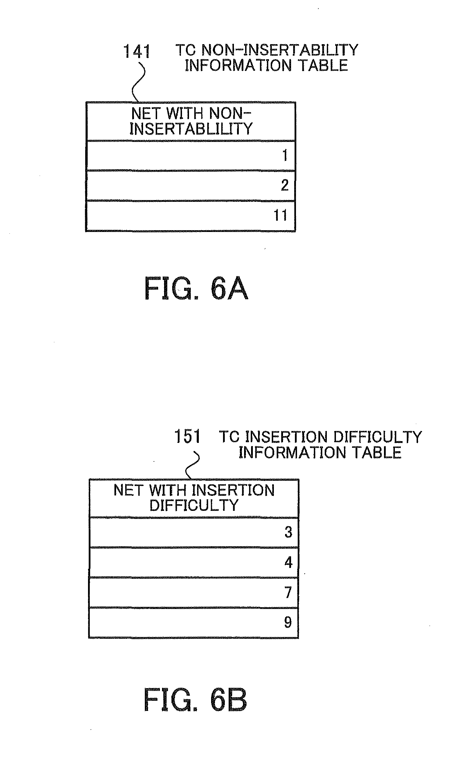

FIGS. 6A and 6B illustrate an example of information stored in a TC non-insertability information storage unit and TC insertion difficulty information storage unit.

The TC non-insertability information table 141 illustrated in FIG. 6A is one example of a table stored in the TC non-insertability information storage unit 14.

In the TC non-insertability information table 141 illustrated in FIG. 6A, the net numbers of nets where a test circuit is determined to be not insertable are stored. In the TC insertion difficulty information table 151 illustrated in FIG. 6B, the net numbers of nets where it is difficult to insert a test circuit are stored.

Referring back to FIG. 3, the display data generation unit 16 creates a logic circuit diagram to be displayed on a monitor 104a. The display data generation unit 16 also determines the radiuses and colors of bubbles to be displayed in the nets of the created logic circuit diagram, according to the test cost values. With respect to bubbles, the display data generation unit 16 does not create bubbles in the nets with net numbers stored in the TC non-insertability information storage unit 14. The display data generation unit 16 colors the bubbles in the nets with the net numbers stored in the TC insertion difficulty information storage unit 15 so as to indicate that it is difficult to insert a test circuit. The display data generation unit 16 outputs the logic circuit diagram where the bubbles are displayed, to the monitor 104a. The logic circuit diagram where bubbles are displayed is one example of the second information.

The following describes the entire process of the design support apparatus 10.

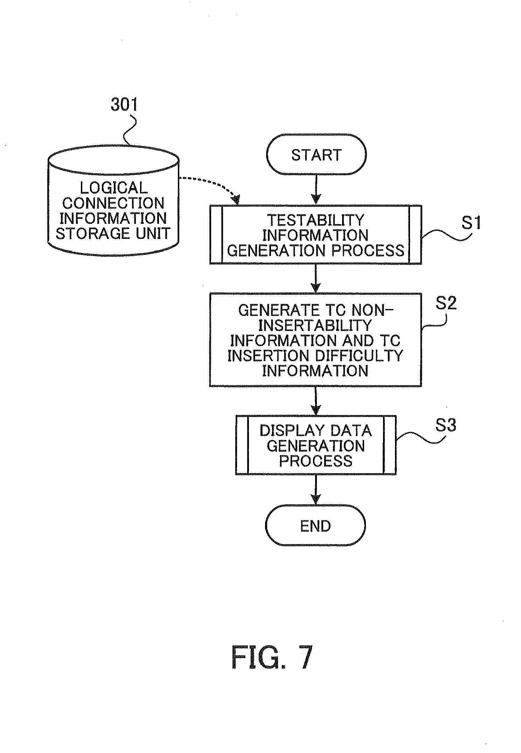

FIG. 7 is a flowchart illustrating an entire process of a design support apparatus according to the second embodiment.

At step S1, the testability analysis unit 11 performs a testability information generation process to generate testability information with reference to logical connection information stored in the logical connection information storage unit 301. Then, the testability analysis unit 11 stores the generated testability information in the testability information storage unit 12. Then, the process proceeds to step S2. The testability information generation process will be described in detail later.

At step S2, the analysis unit 13 creates a TC non-insertability information table 141 and TC insertion difficulty information table 151. More specifically, the logical connection information analysis unit 131 analyzes the logical connection information stored in the logical connection information storage unit 301 to specify a net where a test circuit is not insertable. The implementation information analysis unit 132 analyzes the implementation information stored in the implementation information storage unit 302 to specify a net where a test circuit is not insertable. The delay information analysis unit 133 analyzes the delay information stored in the delay information storage unit 303 to specify a net where a test circuit is not insertable and a net where it is difficult to insert a test circuit. Then, the analysis unit 13 creates a TC non-insertability information table 141 containing the net numbers of the nets where a test circuit is determined to be not insertable, and stores the created TC non-insertability information table 141 in the TC non-insertability information storage unit 14. In addition, the analysis unit 13 creates a TC insertion difficulty information table 151 containing the net numbers of the nets where it is difficult to insert a test circuit, and stores the created TC insertion difficulty information table 151 in the TC insertion difficulty information storage unit 15. Then, the process proceeds to step S3. In this connection, the order of step S1 and step S2 is not fixed.

At step S3, the display data generation unit 16 performs a display data generation process. More specifically, the display data generation unit 16 creates a logic circuit diagram where bubbles are displayed, with reference to the testability information table 121 created at step S1 and the TC non-insertability information table 141 and TC insertion difficulty information table 151 created at step S2. Then, the display data generation unit 16 outputs the generated logic circuit diagram where bubbles are displayed, to the monitor 104a. Then, the process of FIG. 7 is completed. The display data generation process will be described in detail later.

The following describes the testability information generation process that is performed at step S1 of FIG. 7.

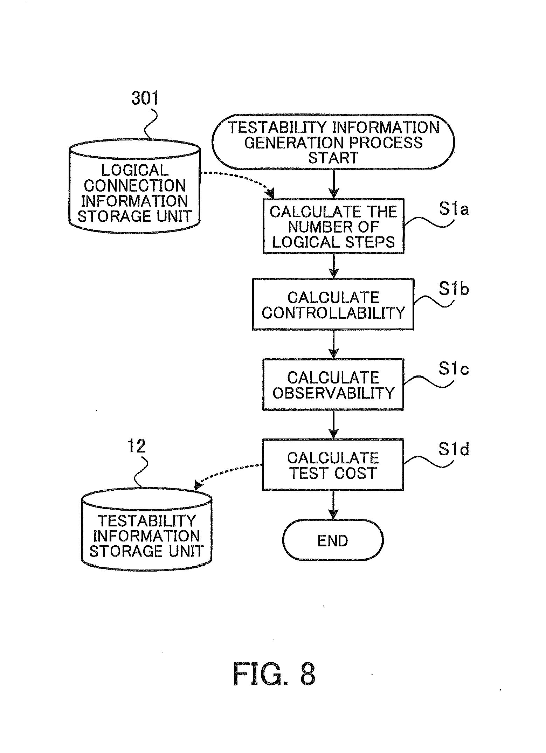

FIG. 8 is a flowchart of a testability information generation process.

At step S1a, the testability analysis unit 11 selects one of nets stored in the logical connection information storage unit 301, and calculates the number of logical steps of the selected net. Then, the process proceeds to step S1b.

At step S1b, the testability analysis unit 11 calculates the controllability of the net selected at step S1a. Then, the process proceeds to step S1c.

At step S1c, the testability analysis unit 11 calculates the observability of the net selected at step S1a. Then, the process proceeds to step S1d.

At step S1d, the testability analysis unit 11 calculates a test cost by using the number of logical steps, controllability, and observability obtained at steps S1a, S1b, and S1c. Then, the testability analysis unit 11 stores the number of logical steps, controllability, observability, and test cost obtained at steps S1a to S1d in association with the net number of the net selected at step S1a in the testability information table 121.

The testability analysis unit 11 processes all nets stored in the logical connection information storage unit 301 through steps S1a to S1d, and then the process of FIG. 8 is completed.

The following describes the process of the analysis unit 13 described at step S2 of FIG. 7 in more detail.

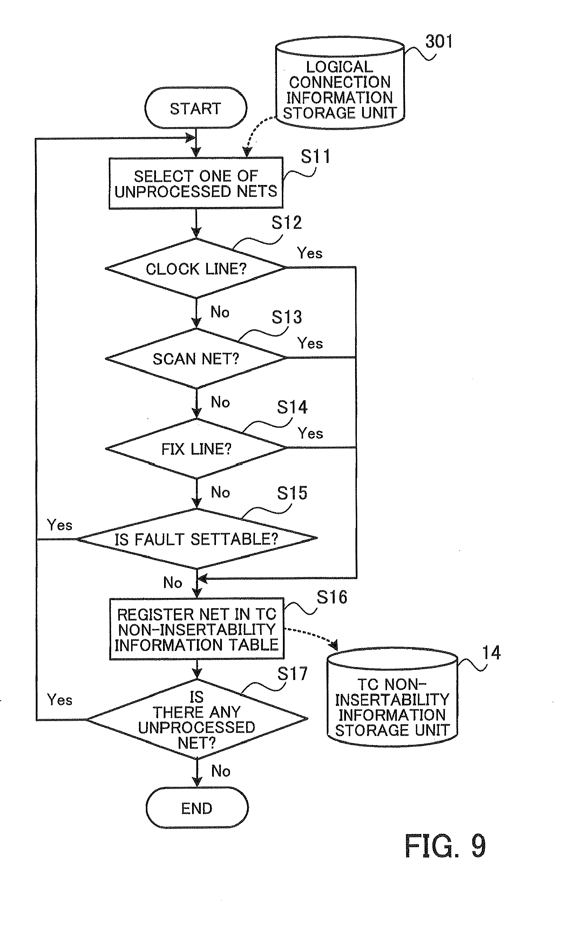

FIG. 9 is a flowchart illustrating the process of the logical connection information analysis unit.

At step S11, the logical connection information analysis unit 131 selects one of unprocessed nets stored in the logical connection information storage unit 301. Then, the process proceeds to step S12.

At step S12, the logical connection information analysis unit 131 determines whether the wiring type of the net selected at step S11 is a clock line or not. If the type is a clock line (yes at step S12), the process proceeds to step S16. Otherwise (no at step S13), the process proceeds to step S13.

At step S13, the logical connection information analysis unit 131 determines whether the wiring type of the net selected at step S11 is a scan net or not. If the type is a scan net (yes at step S13), the process proceeds to step S16. Otherwise (no at step S13), the process proceeds to step S14.

At step S14, the logical connection information analysis unit 131 determines whether the wiring type of the net selected at step S11 is a Fix line or not. If the type is a Fix line (yes at step S14), the process proceeds to step S16. Otherwise (no at step S14), the process proceeds to step S15.

At step S15, the logical connection information analysis unit 131 determines whether a fault is settable or not in the net selected at step S11, with reference to the logical connection information that indicates for each net whether a fault is settable or not. If a fault is settable in the net selected at step S11 (yes at step S15), the process proceeds back to step S11 to repeat step S11 and subsequent steps. Otherwise (no at step S15), the process proceeds to step S16.

At step S16, the logical connection information analysis unit 131 registers the net number of the net selected at step S11 in the TC non-insertability information table 141. Then, the process proceeds to step S17.

At step S17, the logical connection information analysis unit 131 determines whether there is any unprocessed net in the logical connection information storage unit 301 or not. If there is an unprocessed net (yes at step S17), the process proceeds back to step S11 to repeat step S11 and subsequent steps. Otherwise (no at step S17), the process of FIG. 9 is completed.

The following describes the process of the implementation information analysis unit 132 with reference to a flowchart.

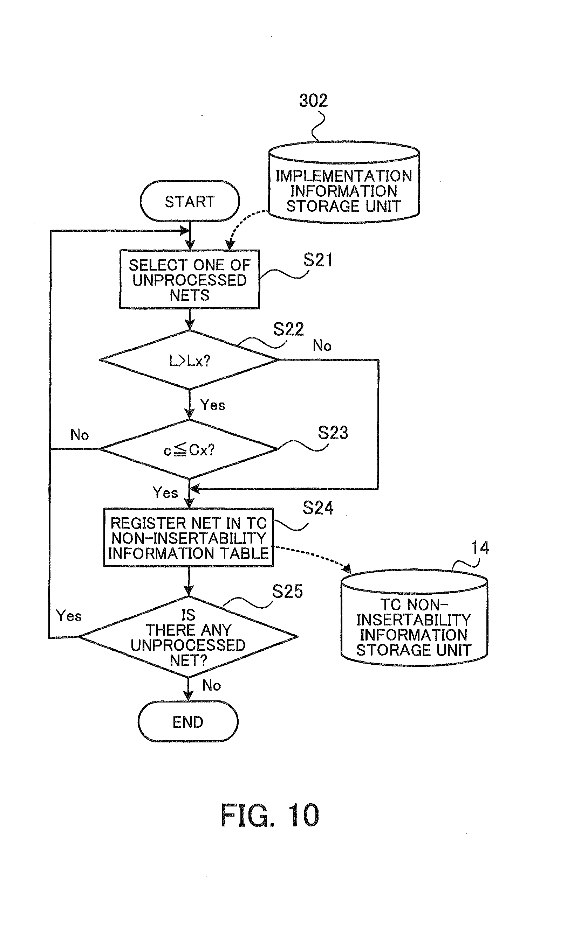

FIG. 10 is a flowchart illustrating a process of the implementation information analysis unit.

At step S21, the implementation information analysis unit 132 selects one of unprocessed nets stored in the implementation information storage unit 302. Then, the process proceeds to step S22.

At step S22, the implementation information analysis unit 132 determines whether or not the width L of space between the net selected at step S21 and its adjacent wiring line is greater than a sufficient width Lx. If the width L of the space is greater than the sufficient width Lx (yes at step S22), the process proceeds to step S23. Otherwise (no at step S22), the process proceeds to step S24.

At step S23, the implementation information analysis unit 132 determines whether or not the gate density c of the net selected at step S21 is equal to or lower than the gate density Cx of the LSI included in the implementation information. If the gate density c is equal to or lower than the gate density Cx (yes at step S23), the process proceeds to step S24. Otherwise (no at step S23), the process proceeds back to step S21 to repeat step S21 and subsequent steps.

At step S24, the implementation information analysis unit 132 registers the net number of the net selected at step S21 in the TC non-insertability information table 141. Then, the process proceeds to step S25.

At step S25, the implementation information analysis unit 132 determines whether there is any unprocessed net in the implementation information storage unit 302 or not. If there is an unprocessed net in the implementation information storage unit 302 (yes at step S25), the process proceeds to step S21. Otherwise (no step S25), the process of FIG. 10 is completed.

The following describes the process of the delay information analysis unit 133 with reference to a flowchart.

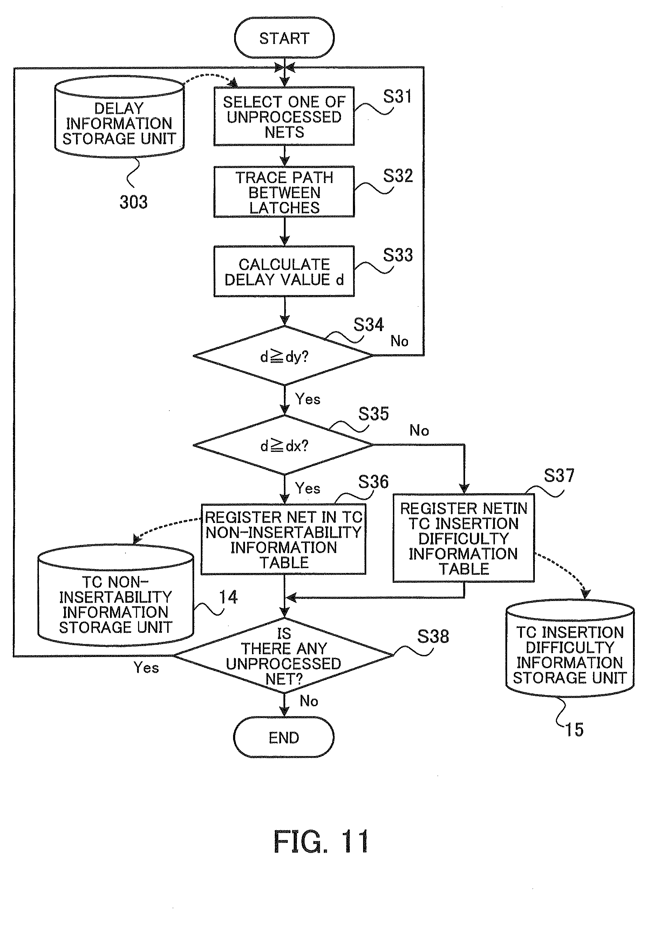

FIG. 11 is a flowchart illustrating a process of the delay information analysis unit.

At step S31, the delay information analysis unit 133 selects one of unprocessed nets stored in the delay information storage unit 303. Then, the process proceeds to step S32.

At step S32, the delay information analysis unit 133 traces a path with the maximum delay time of a latch out of the latches passing through the net selected at step S31. Then, the process proceeds to step S33.

At step S33, the delay information analysis unit 133 calculates the delay time d of the path traced at step S32 based on the delay information stored in the delay information storage unit 303. Then, the process proceeds to step S34.

At step S34, the delay information analysis unit 133 determines whether or not the delay time d is equal to or greater than the difficulty value dy of the path delay time. The difficulty value dy may desirably be set by a circuit designer to a value smaller than the delay limit value dx of the critical path. The aforementioned 470ps is one example of the difficulty value dy. If the delay time d is equal to or greater than the difficulty time dy (yes at step S34), the process proceeds to step S35. Otherwise (no at step S34), the process proceeds back to step S31 to repeat step S31 and subsequent steps.

At step S35, the delay information analysis unit 133 determines whether or not the delay time d is equal to or greater than the limit value dx of the path delay time. The aforementioned 485ps is one example of the limit value dx. If the delay time d is equal to or greater than the limit value dx (yes at step S35), the process proceeds to step S36. Otherwise (no at step S35), the process proceeds to step S37.

At step S36, the delay information analysis unit 133 stores the net number of the net selected at step S31 in the TC non-insertability information table 141. Then, the process proceeds to step S38.

At step S37, the delay information analysis unit 133 stores the net number of the net selected at step S31 in the TC insertion difficulty information table 151. Then, the process proceeds to step S38.

At step S38, the delay information analysis unit 133 determines whether there is any unprocessed net in the delay information storage unit 303 or not. If there is an unprocessed net in the delay information storage unit 303 (yes at step S38), the process proceeds back to step S31 to repeat step S31 and subsequent steps. Otherwise (no at step S38), the process of FIG. 11 is completed.

The following describes the display data generation process of step S3 of FIG. 7 in more detail.

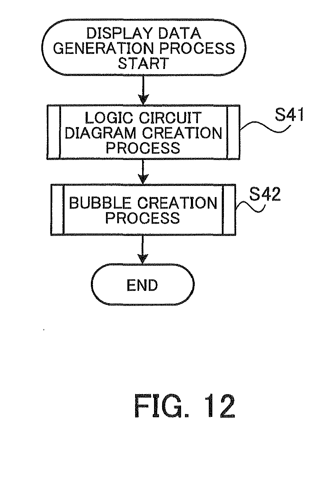

FIG. 12 is a flowchart of a display data generation process.

At step S41, the display data generation unit 16 performs a logic circuit diagram creation process to create a logic circuit diagram. When creation of a logic circuit diagram is completed, the process proceeds to step S42.

At step S42, the display data generation unit 16 performs a bubble creation process to create bubbles in the logic circuit diagram created at step S41. Then, the process of FIG. 12 is completed.

The following describes a logic circuit diagram creation process of step S41.

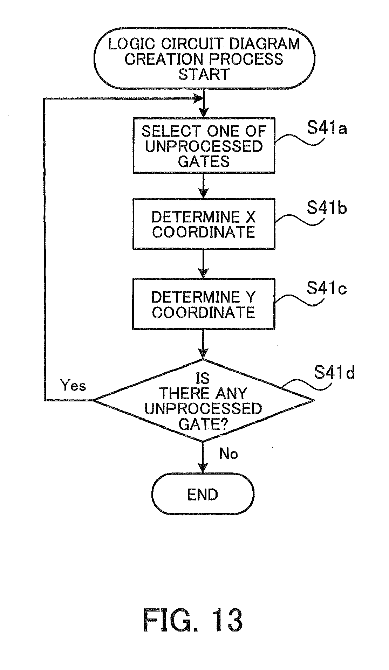

FIG. 13 is a flowchart of a logic circuit diagram creation process.

At step S41a, the display data generation unit 16 selects one of unprocessed gates stored in the logical connection information storage unit 301. Then, the process proceeds to step S41b.

At step S41b, the display data generation unit 16 determines X coordinate for arranging the gate selected at step S41a in the logic circuit diagram. For example, the display data generation unit 16 sets the original point (0, 0) in the logic circuit diagram, and sets the X coordinate of the selected gate such that the input side of a signal is set closer to the X coordinate of the original point and the output side of the signal is set farther than the X coordinate of the original point. Then, the process proceeds to step S41c.

At step S41c, the display data generation unit 16 determines Y coordinate for arranging the gate selected at step S41a in the logic circuit diagram. Then, the process proceeds to step S41d.

At step S41d, the display data generation unit 16 determines whether there is any unprocessed gate in the logical connection information storage unit 301 or not. If there is an unprocessed gate in the logical connection information storage unit 301 (yes at step S41d), the process proceeds back to step S41a to repeat step S41a and subsequent steps. Otherwise (no at step S41d), the process of FIG. 13 is completed.

The following describes the bubble creation process of step S42.

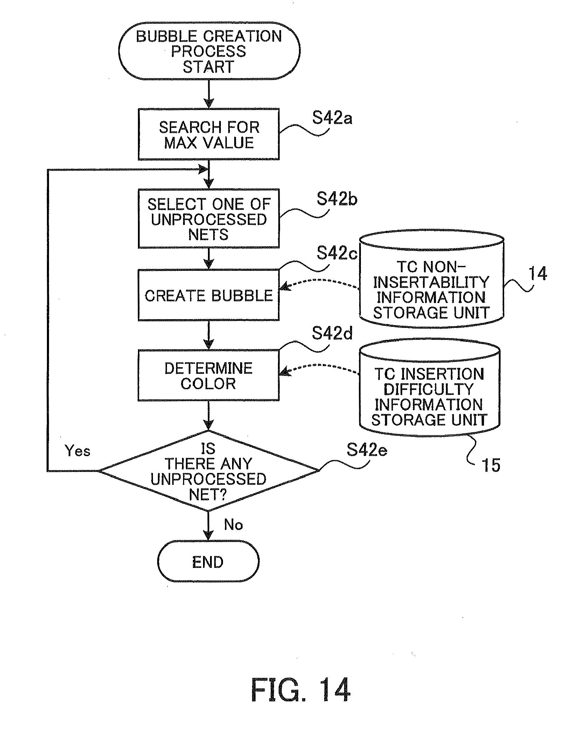

FIG. 14 is a flowchart of a bubble creation process.

At step S42a, the display data generation unit 16 searches the values set in the test cost column of the testability information table 121 stored in the testability information storage unit 12 for the maximum value (hereinafter, referred to as MAX value). Then, the process proceeds to step S42b.

At step S42b, the display data generation unit 16 selects one of unprocessed nets stored in the logical connection information storage unit 301. Then, the process proceeds to step S42c.

At step S42c, the display data generation unit 16 creates a bubble to be displayed in the selected net of the logic circuit diagram. More specifically, the display data generation unit 16 determines the maximum radius of bubbles to be displayed in the logic circuit diagram with the MAX value found at step S42a as a relative value of 1. Then, the display data generation unit 16 determines the radius of the bubble to be displayed in the selected net by dividing the test cost of the selected net by the MAX value. In this connection, the display data generation unit 16 does not create a bubble for the nets of net numbers stored in the TC non-insertability information table 141. Then, the process proceeds to step S42d.

At step S42d, the display data generation unit 16 determines the color of the bubble displayed in the logic circuit at step S42c. More specifically, the display data generation unit 16 colors a bubble in red if the division result obtained at step S42c is 0.8 or greater, in blue if the division result is 0.2 or greater and less than 0.8, and in black if the division result is less than 0.2. Then, the display data generation unit 16 compares the net with a red bubble with the nets stored in the TC insertion difficulty information table 151. The display data generation unit 16 changes the colors of the bubbles of nets stored in the TC insertion difficulty information table 151 from red to yellow. Then, the process proceeds to step S42e.

At step S42e, the display data generation unit 16 determines whether or not there is any net which has not been subjected to steps S42c and 42d in the logical connection information storage unit 301. If there is such an unprocessed net (yes at step S42e), the process proceeds back to step S42b to repeat step S42b and subsequent steps. Otherwise (no at step S42e), the process of FIG. 14 is completed.

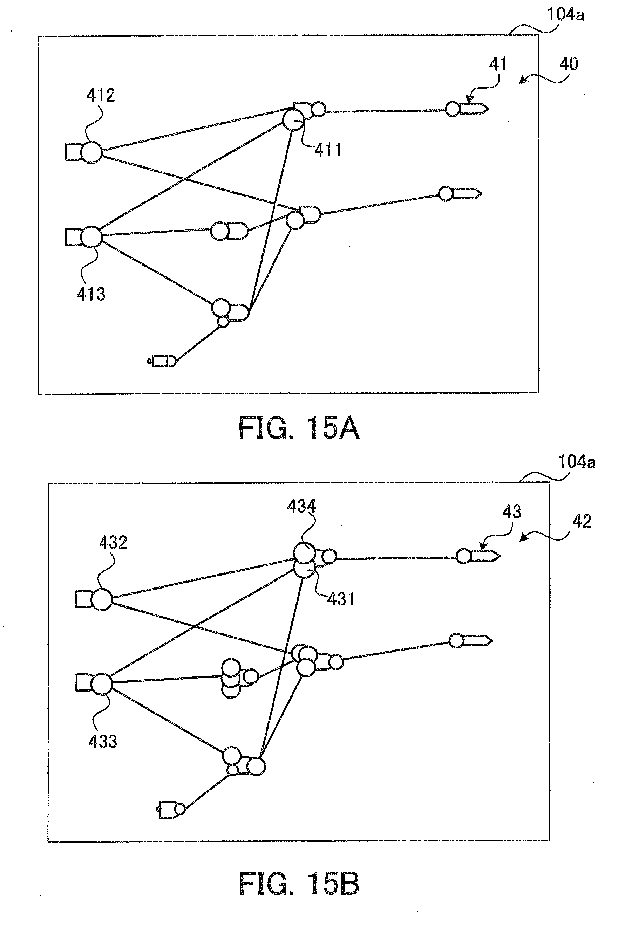

FIGS. 15A and 15B illustrate examples of a logic circuit diagram to be displayed on a monitor.

FIG. 15A illustrates a screen 40 displayed by the display data generation unit 16 on the monitor 104a. In the logic circuit diagram 41, the bubble 411 is colored in red at step S42d of FIG. 14. The bubbles 412 and 413 are colored in yellow at step S42d of FIG. 14.

FIG. 15B illustrates a screen 42 for comparison with the screen 40 by way of example. This screen 42 is created by creating bubbles without the TC insertion difficulty information table 141 at step S42c and coloring the bubbles without the TC insertion difficulty information table 151 at step S42d. The bubbles 431, 432, and 433 correspond to the bubble 411, 412, and 413, respectively, and are all colored in red. In addition, the bubble 434 is one example of a bubble created in a net where a test circuit is not insertable.

As described above, in the design support apparatus 10, the logic circuit diagrams 41 and 43 where bubbles are displayed in nets are created, as illustrated in the screens 40 and 42, so that the circuit designer is able to easily confirm the insertion positions of test circuits. Further, the logic circuit diagram 41 where bubbles are displayed only at positions in nets where test circuits are insertable with reference to the implementation information and timing information allows the circuit designer to easily confirm the insertion positions of the test circuits which are hardly affected by delay and noise. In addition, the circuit designer is able to determine whether to insert a test circuit, based on the positions of bubbles colored in yellow in the logic circuit diagram 41. Furthermore, inserting a test circuit at the position of a bubble in the logic circuit diagram 41 reduces rework to be performed by the circuit designer in the later design process.

In this connection, it may be so designed that the design support apparatus 10 automatically inserts a test circuit in a net where a red bubble is displayed in the logic circuit diagram 41 and the circuit designer manually inserts a test circuit in a net where a yellow bubble is displayed in the logic circuit diagram 41.

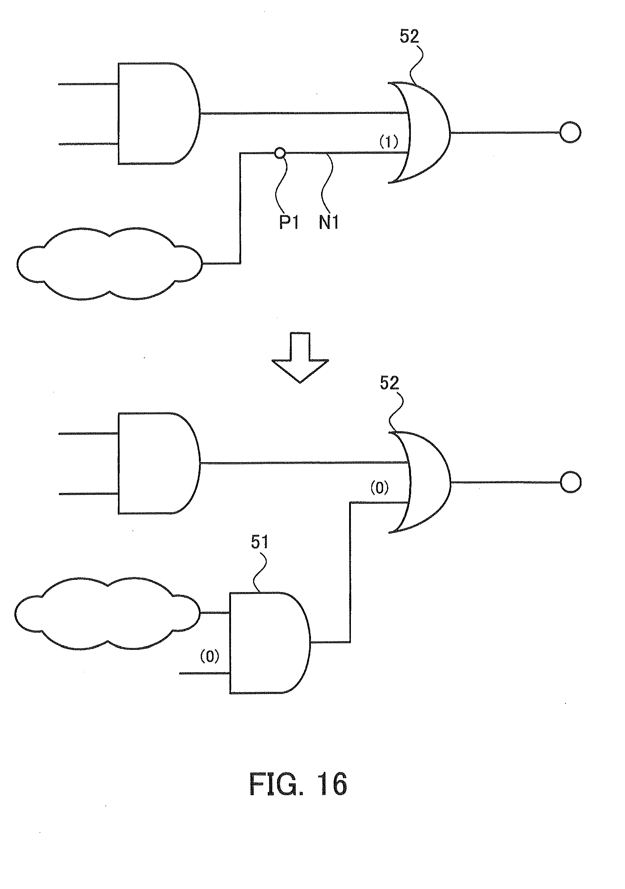

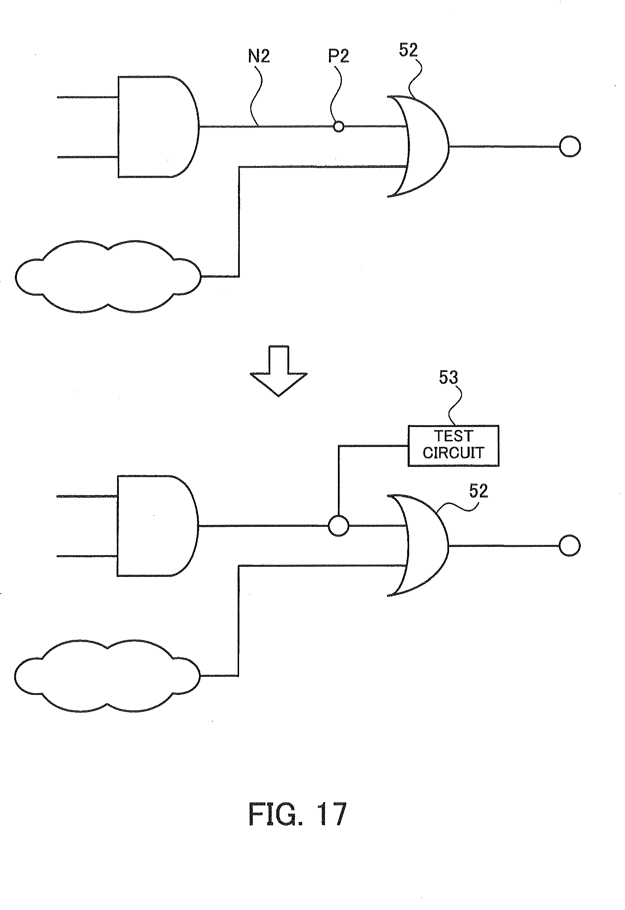

FIGS. 16 and 17 illustrate examples of insertion of a test circuit.

FIG. 16 illustrates an example where a test circuit 51 for improving 0-controllability is inserted at an insertion position P1 of a test circuit in a net N1. The test circuit 51 is an AND gate. The test circuit 51 is inserted at a position where the logic of the input terminal of an OR gate 52 is 1, and 0 is supplied to the input terminal of the test circuit 51, so as to set the logic of the input terminal of the OR gate 52 to 0.

FIG. 17 illustrates an example where a test circuit 53 for improving observability is inserted at an insertion position P2 of a test circuit in a net N2. The test circuit 53 is inserted at a position where the logic of the input terminal of an OR gate 52 is 1, so as to make the logic of the net N2 observable.

### (c) Third Embodiment

The following describes a design support apparatus according to a third embodiment.

The following mainly describes different features of the design support apparatus of the third embodiment from that of the second embodiment, and the same features will not be described again.

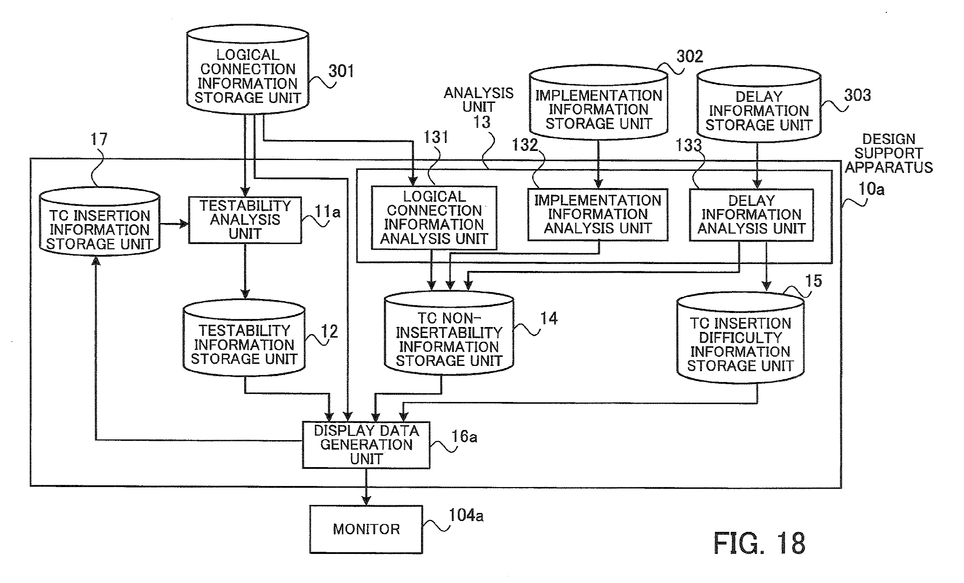

FIG. 18 is a functional block diagram of a design support apparatus according to the third embodiment.

The design support apparatus 10a of the third embodiment has a testability analysis unit 11a and display data generation unit 16a that have different functions from the corresponding units of the second embodiment. In addition, the design support apparatus 10a further includes a TC insertion information storage unit 17. In this connection, the testability analysis unit 11a is one example of the third generation unit.

The display data generation unit 16a generates test circuit insertion information that indicates the type of a test circuit inserted by a circuit designer and a net where the test circuit has been inserted in a created logic circuit diagram, in addition to the functions of the display data generation unit 16. Then, the display data generation unit 16a stores the generated test circuit insertion information in the TC insertion information storage unit 17.

The testability analysis unit 11a reads the test circuit insertion information specified by the circuit designer from the TC insertion information storage unit 17, in addition to the functions of the testability analysis unit 11. The testability analysis unit 11a sets the test circuit in the logical connection information stored in the logical connection information storage unit 301 on the basis of the insertion position of the test circuit indicated by the read test circuit insertion information.

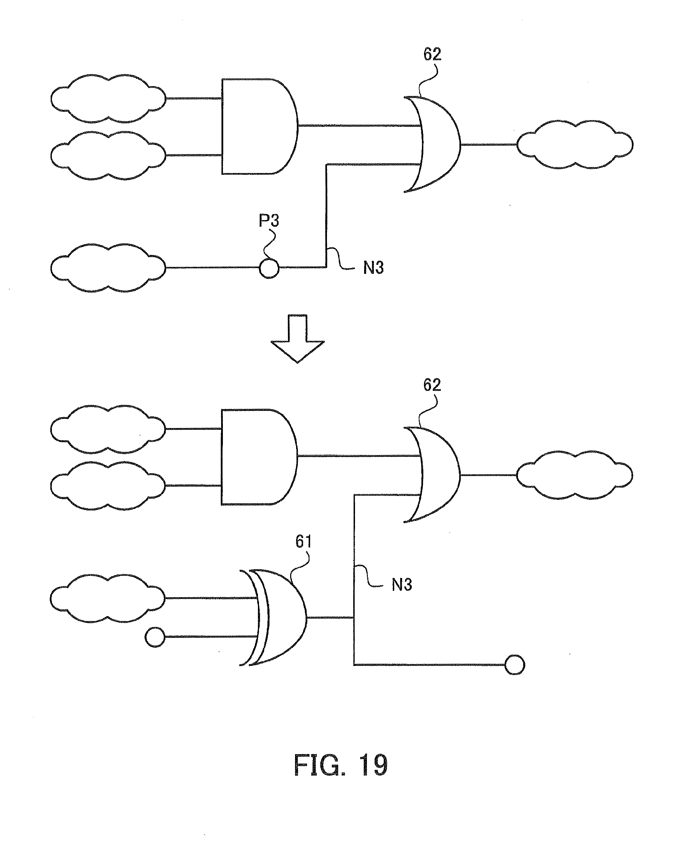

FIG. 19 illustrates an example of insertion of a test circuit according to the third embodiment.

FIG. 19 illustrates an example where a test circuit 61 is inserted at an insertion position P3 of a test circuit in a net N3. The test circuit 61 is a NOR gate. The test circuit 61 is inserted at a position where the logic of the input terminal of the OR gate 62 is 1, and 0 is supplied to the input terminal of the test circuit 61, so as to set the logic of the input terminal of the OR gate 62 to 1 or 0. In addition, by observing the logic of the output terminal of the test circuit 61, it becomes possible to observe the logic of the net N3.

The testability analysis unit 11a obtains testability information by using the logical connection information in which the test circuit insertion information is reflected, in the same way as the second embodiment.

The following describes the entire process of the design support apparatus 10a of the third embodiment.

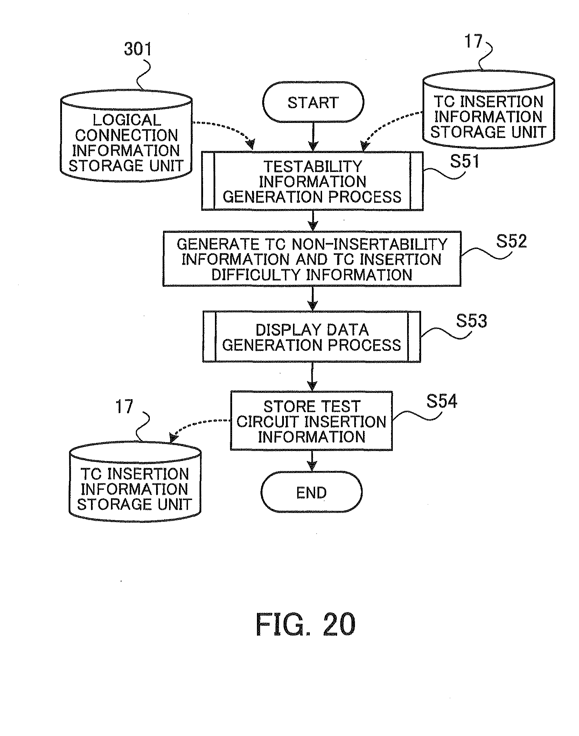

FIG. 20 is a flowchart illustrating an entire process of a design support apparatus according to the third embodiment.

At step S51, the testability analysis unit 11a performs a testability information generation process to create a testability information table 121, with reference to the logical connection information stored in the logical connection information storage unit 301 and the test circuit insertion information stored in the TC insertion information storage unit 17. Then, the testability analysis unit 11a stores the created testability information tale 121 in a testability information storage unit 12. Then, the process proceeds to step S52. This testability information generation process will be described in detail later.

At step S52, the analysis unit 13 performs the same process as step S2 of FIG. 7. Then, the process proceeds to step S53.

At step S53, the display data generation unit 16a performs the same process as step S3 of FIG. 7. Then, the process proceeds to step S54.

At step S54, the display data generation unit 16a generates test circuit insertion information indicating nets where test circuits have been inserted. Then, the display data generation unit 16a stores the generated test circuit insertion information in the TC insertion information storage unit 17. Then, the process of FIG. 20 is completed.

The following describes the testability information generation process of step S51 of FIG. 20.

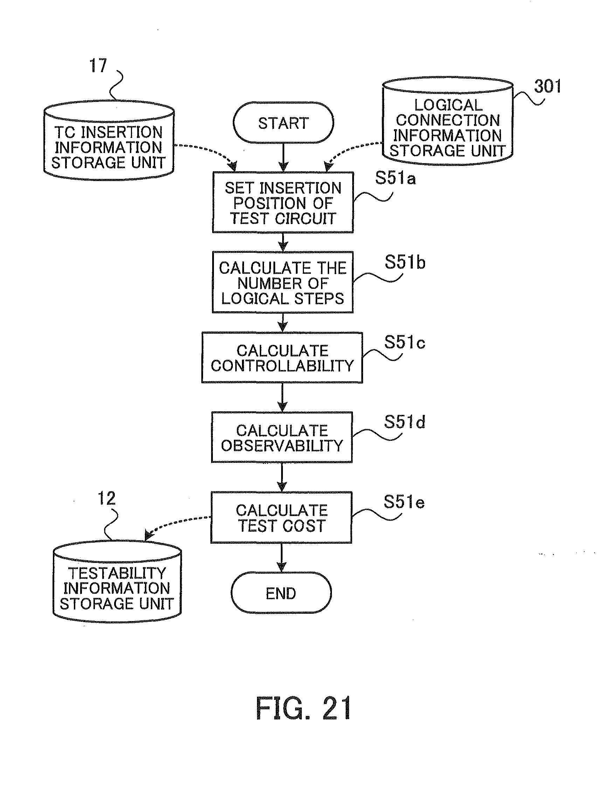

FIG. 21 is a flowchart of a testability information generation process according to the third embodiment.

At step S51a, the testability analysis unit 11a sets a test circuit in the logical connection information stored in the logical connection information storage unit 301 on the basis of the insertion position of the test circuit indicated by the test circuit insertion information stored in the TC insertion information storage unit 17. Then, the process proceeds to step S51b.

At step S51b, the testability analysis unit 11a performs the same process as step S1a of FIG. 8 on the logical connection information where a test circuit has been inserted. Then, the process proceeds to step S51c.

At step S51c, the testability analysis unit 11a performs the same process as step S1b of FIG. 8. Then, the process proceeds to step S51d.

At step S51d, the testability analysis unit 11a performs the same process as step S1c of FIG. 8. Then, the process proceeds to step S51e.

At step S51e, the testability analysis unit 11a performs the same process as step S1d of FIG. 8. Then, the process of FIG. 21 is completed.

The design support apparatus 10a according to the third embodiment produces the same effects as the second embodiment.

In addition, the design support apparatus 10a according to the third embodiment reduces a circuit designer's work of re-inserting a test circuit at the time of re-design work.

In this connection, the process performed by the design support apparatus 10, 10a may be performed by a plurality of apparatuses in a distributed manner. For example, one apparatus may be designed to create the testability information table 121, TC non-insertability information table 141, and TC insertion difficulty information table 151, and another apparatus may be designed to generate display data with reference to these tables.

Heretofore, the design support apparatuses and design support methods according to the illustrated embodiments have been described, but are not limited thereto. The described components may be replaced with other components having equivalent functions or may include other components or processing operations. Where appropriate, other components and features may be added. In addition, desired two or more configurations (features) in the embodiments may be combined.

The above processing functions can be realized by using a computer. In this case, a program is prepared, which describes processes for the functions of the design support apparatus 1, 10, and 10a. A computer realizes the above processing functions by executing the program. The program describing the intended processes may be recorded on a computer-readable recording medium. Computer-readable recording media include magnetic recording devices, optical discs, magneto-optical recording media, semiconductor memories, etc. The magnetic recording devices include Hard Disk Drives, Flexible Disks (FD), Magnetic Tapes, etc. The optical discs include DVDs, DVD-RAMs, CD-ROM/RW, etc. The magneto-optical recording media include MOs (Magneto-Optical disk), etc.

To distribute the program, portable recording media, such as DVDs and CD-ROMs, on which the program is recorded, may be put on sale. Alternatively, the program may be stored in the storage device of a server computer and may be transferred from the server computer to other computers through a network.

A computer which is to execute the above program stores in its local storage device the program recorded on a portable recording medium or transferred from the server computer, for example. Then, the computer reads the program from the local storage device, and runs the program. The computer may run the program directly from the portable recording medium. Also, while receiving the program being transferred from the server computer, the computer may sequentially run this program.

In addition, the above-described processing functions may also be implemented wholly or partly by using a digital signal processor (DSP), application-specific integrated circuit (ASIC), programmable logic device (PLD), or other electronic circuits.

According to one aspect, a net where a test circuit is to be inserted is specified.

## Claims

1. A design support apparatus (1, 10, 10a) comprising:
first generation means (1a, 13) to generate, with reference to logical connection information of a semiconductor integrated circuit to be designed, first information (3, 141) indicating logical connection information where a test circuit used for testing operation of the semiconductor integrated circuit is not to be inserted;
storage means to store the first information (3, 141); and
second generation means (1c, 16) to generate second information (7, 41) indicating logical connection information where the test circuit is to be inserted, by excluding the logical connection information indicated by the first information (3, 141) stored in the storage means from logical connection information (6, 121) whose parameters indicate difficulties of controllability and observability of a signal that propagates in the semiconductor integrated circuit.

2. The design support apparatus (1, 10, 10a) according to claim 1, wherein the first generation means (1a, 13) generates the first information (3, 141) according to a type of wiring included in the logical connection information of the semiconductor integrated circuit.

3. The design support apparatus (1, 10, 10a) according to claim 1, wherein the first generation means (1a, 13) further generates the first information (3, 141) with reference to wiring layout information including distance information between adjacent wiring lines of the semiconductor integrated circuit.

4. The design support apparatus (1, 10, 10a) according to claim 1, wherein the first generation means (1a, 13) further generates the first information (3, 141) with reference to wiring delay information including information about a delay time of each wiring line of the semiconductor integrated circuit.

5. The design support apparatus (1, 10, 10a) according to claim 1, wherein:
the first generation means (133) further generates third information (151) regarding logical connection information indicating that insertion of the test circuit is difficult, with reference to wiring delay information including information about a delay time of each wiring line of the semiconductor integrated circuit; and
the design support apparatus (1, 10, 10a) further includes display means (16) to display the third information (151) on a display device (104a).

6. The design support apparatus (1, 10, 10a) according to claim 5, wherein the display means (16) displays the third information (151) in a distinguishable manner from the second information (41).

7. The design support apparatus (1, 10, 10a) according to claim 1, further comprises display means (1d, 16) to display the second information (7, 41) generated by the second generation means (1c, 16) on a display device (8, 104a).

8. The design support apparatus (10a) according to claim 1, further comprising third generation means to generate logical connection information indicating that one or both of the controllability and observability of the signal that propagates in the semiconductor integrated circuit is difficult, with reference to the second information.

9. A design support method executed by a computer (1, 10, 10a), the method comprising:
generating, with reference to logical connection information of a semiconductor integrated circuit to be designed, first information (3, 141) indicating logical connection information where a test circuit used for testing operation of the semiconductor integrated circuit is not to be inserted; and
generating second information (7, 41) indicating logical connection information where the test circuit is to be inserted, by excluding the logical connection information indicated by the generated first information (3, 141) from logical connection information (6, 121) whose parameters indicate difficulties of controllability and observability of a signal that propagates in the semiconductor integrated circuit.

10. A computer program which causes a computer (1, 10, 10a) to perform a procedure comprising:
generating, with reference to logical connection information of a semiconductor integrated circuit to be designed, first information (3, 141) indicating logical connection information where a test circuit used for testing operation of the semiconductor integrated circuit is not to be inserted; and
generating second information (7, 41) indicating logical connection information where the test circuit is to be inserted, by excluding the logical connection information indicated by the generated first information (3, 141) from logical connection information (6, 121) whose parameters indicate difficulties of controllability and observability of a signal that propagates in the semiconductor integrated circuit.
